# EUROPÄISCHE PATENTSCHRIFT

(11) **EP 0 399 998 B1**
(45) Veröffentlichungstag und Bekanntmachung des Hinweises auf die Patenterteilung: **16.09.1998**
(21) Anmeldenummer: 90890163.0
(22) Anmeldetag: 25.05.1990
(51) Int. Cl.: G03F 1/16

(54) **Verfahren zur Herstellung von hochauflösenden Silizium-Schattenmasken**
Process for the fabrication of high definition silicon shadow masks
Procédé de fabrication de masques d'ombre en silicium de haute définition

(30) Priorität: 26.05.1989 US 357481
(43) Veröffentlichungstag der Anmeldung: 28.11.1990
(73) Patentinhaber: IMS Ionen Mikrofabrikations Systeme Gesellschaft m.b.H., A-1020 Wien (AT); NANOSTRUCTURES, INC., Mountain View California 94043 (US)
(72) Erfinder: Mauger, Philip E., Santa Clara, California 95051 (US); Shimkunas, Alex R., Palo Alto, California 94306 (US); Yen, Junling J., Cupertino, California 95014 (US)
(74) Vertreter: Matschnig, Franz, Dipl.-Ing.

(56) Entgegenhaltungen:
- EP-A- 367 750
- EP-A- 0 001 038
- SOVIET PHYSICS DOKLADY. vol. 30, no. 9, September 1985, NEW YORK US Seiten 797 - 799; K. A. VALIEV et al.: "High-contrast stencil masks for high-voltage electronic lithography"
- IBM TECHNICAL DISCLOSURE BULLETIN. vol. 30, no. 11, April 1988, NEW YORK US Seiten 392 - 393; "Improved E-beam proximity mask"
- JOURNAL OF VACUUM SCIENCE AND TECHNOLOGY: PART B. vol. B6, no. 6, Dezember 1988, NEW YORK US Seiten 2112 - 2114; F. O. FONG et al.: "High-resolution fabrication process for silicon ion masks"
- JOURNAL OF VACUUM SCIENCE AND TECHNOLOGY: PART B. vol. B6, no. 1, Februar 1988, NEW YORK US Seiten 257 - 262; A. M. El-Masary et al.: "Magnetically enhanced reactive ion etching of silicone in bromine plasmas"

## Beschreibung

### HINTERGRUND DER ERFINDUNG

### BEREICH DER ERFINDUNG

Diese Erfindung betrifft die Herstellung einer hochauflösenden Schattenmaske zur Verwendung für Elektronen-, Ionenstrahl- oder Röntgenlithographie, Ionenimplantation und Ionenstrahlätzung.

### HINTERGRUND

Geladene Partikelstrahlen (Elektronen oder Ionen) werden weitgehend zur Herstellung von Halbleitervorrichtungen verwendet. Um die hohe Auflösung, die für lithographische Anwendungen erforderlich ist, zu erreichen, werden die Strahlen auf einen kleinen Punkt gebündelt, mit welchem danach das Substrat abgetastet wird. Wegen der geringen Punktgrößen kann die Abtastzeit sehr lange sein, wenn große Flächen bedeckt werden müssen. Eine Alternative zur Abtastung mittels gebündelter Strahlen ist die Verwendung von breitflächigen Strahlen, deren Struktur durch Schattenmasken definiert wird. Eine Schattenmaske besteht aus einem dünnen Substrat (üblicherweise einer Membran), das mit Löchern strukturiert wurde, um die Ionen oder Elektronen durch die Maske durchzulassen. Bei diesem Verfahren können gleichzeitig viele Strukturelemente über eine große Fläche verarbeitet werden und folglich kann das lithographische Verfahren weitaus rascher durchgeführt werden.

Schattenmasken können entweder in einem nach dem Proximity Modus oder in einem nach dem Projektionsmodus arbeitenden System verwendet werden. Bei Arbeit nach dem Proximity Modus wird die Maske nahe an dem Wafer, der strukturiert werden soll, angebracht. Die Struktur wird auf den Wafer durch einfache Schattenabbildung übertragen, und die Maskenstruktur wird auf dem Wafer in einem 1 zu 1 Verhältnis wiedergegeben. Bei Arbeit nach dem Projektionsmodus wird die Maske in einem Linsensystem angebracht, so daß das Muster der Ionen und Elektronen, die von der Maske ausgehen, auf den Wafer fokussiert werden kann, obowhl die Maske und der Wafer nicht in nahem Kontakt zueinander stehen. Ein Projektionsmodus kann im Verhältnis 1 zu 1 oder mit einem Vergrößerungsfaktor abbilden.

Schattenmasken können auch bei der Ionenimplantation oder beim Ionenstrahlätzen zweckmäßig sein. Bei diesen Verfahren, wie sie im allgemeinen durchgeführt werden, werden auf die Oberfläche jedes einzelnen Wafers Maskierungsschichten aufgebracht. Dann werden die Maskierungsschichten durch herkömmliche Lithographieverfahren strukturiert. Jeder Wafer wird mit der Strukturdefinition der Maskierungsschichten dem Ionenstrahl ausgesetzt. Nach Abschluß des Implantations- oder Ätzverfahrens müssen die Maskierungsschichten entfernt werden. Die Verwendung von Schattenmasken für die Strukturdefinition würde das Auftragen und Strukturieren von Maskierungsschichten auf jedem Wafer überflüssig machen und dadurch die Verfahrensdauer beträchtlich verringern.

Die Verwendung von Silizium-Schattenmasken zur Ionenimplantation wurde von Lepselter et al im U.S. Patent Nr. 3,?13,922 beschrieben. Die Masken, die Lepselter beschrieb, bestehen aus dünnen Membranen aus Silizium, die von einem Gitter aus stärkeren Verstärkungsrippen getragen werden. Die Membrane bestehend aus n-leitendem Material und werden vorzugsweise durch ein Ätz-Stopp-Verfahren unter Verwendung von n+ dotierten Stützwafern gebildet. Die Verwendung eines Verstärkungsgitters bedeutet eine große Einschränkung, da sie die Chipgröße, die strukturiert werden kann, begrenzt. Lepselter schlägt bei der Anwendung dieses Verfahrens Chipgrößen von 50 bis 500 µm vor. Derzeit verlangen Schaltungen mit Höchstintegration (VLSI-Schaltungen) Chipgrößen mit Seitenlängen bis zu 12 bis 15 mm. Voraussichtlich werden zukünftige Entwicklungen in der VLSI Technologie noch größere Chipgrößen erfordern. Schattenmasken für solche Chipgrößen sollten daher freitragende Membranen mit Seitenlängen von zumindest einigen Zentimetern haben.

Andere, bekannte Verfahren zur Herstellung einer Siliziummaske sind beispielsweise in der EP-A-1 038 von Magdo et al (IBM) beschrieben. Die Membran für diese Maske wird bei diesen bekannten Verfahren durch einen naßchemischen Dotierungsätzstop eines p/p+-Überganges erzeugt. Bei diesem bekannten Verfahren besteht keine Möglichkeit, die Spannung der so hergestellten Membran kontrolliert einzustellen. Weitere Schattenmaskentechniken werden von Bohlen et al in den U.S. Patenten Nr. 4,417,946 und 4,448,865; und von Behringer im U.S. Patent Nr. 4,589,952 beschrieben. Das grundlegende Verfahren zur Herstellung von Membranen in all diesen Erfindungen ist die Herstellung einer hochdotierten p+ Membran durch selektives Ätzen eines gering dotierten Substrates.

Bei den Verfahren von Lepselter, Bohlen und Behringer werden immer die Schaltungsstrukturen auf der Schattenmaske definiert, bevor die Membran erzeugt wird. Zu diesem Zweck wird zunächst die Siliziumschicht, die letztendlich die Membran bildet, strukturiert, während der Stützwafer intakt bleibt. Der Stützwafer wird in der Folge in jenem Bereich weggeätzt, der die Membran bildet. Magdo wendet die umgekehrte Reihenfolge an, indem zunächst die Membran durch Wegätzen des darunterliegenden Substrates gebildet wird, und danach die Membran zur Herstellung der Schattenmaske strukturiert wird.

Zur Fertigung einer Schattenmaske, die für die Herstellung von Halbleitern verwendbar ist, müssen verschiedene Anforderungen erfüllt werden. übliche Strukturelemente in VLSI-Konstruktionen haben derzeit eine Ausdehnung von weniger als 1 µm und weitere Entwicklungen lassen Abmessungen von nur 0,25 µm erwarten. Daher müssen durch jedes Herstellungsverfahren Schattenmasken mit öffnungen in dieser Größenordnung herstellbar sein. Wie bereits erwähnt, erfordern die Chipgrößen, daß die freitragenden Maskenbereiche einige Zentimeter groß sind. Eine weitere Anforderung, der bei Schattenmasken besondere Bedeutung zukommt, ist, die Strukturverzerrung unter gewissen Grenzwerten zu halten. Da herkömmliche integrierte Schaltkreise mehrere strukturierte Schichten aufweisen, ist es für eine einwandfreie Funktion des fertigen Produktes erforderlich, daß die Struktur jeder Schicht hinsichtlich ihrer Lage exakt mit der Struktur aller anderen Schichten übereinstimmt. üblicherweise wird gefordert, daß über dem Chipbereich die Strukturverzerrung auf einem Zehntel der geringsten Feature-Abmessung (Strukturweite) gehalten wird. Für die oben erwähnten Chipgrößen und Abmessungen (Strukturweiten) mündet diese Forderung in der Einschränkung, daß die Strukturplazierung von Strukturelementen auf der Maske über den Maskenbereich auf wenige Parts per million genau sein muß, oder innerhalb eines geringen Toleranzbereiches von 100 nm liegen muß.

Die Forderung nach geringer Strukturverzerrung führt zu einer wichtigen Beschränkung des erlaubten Wertes der inneren Spannung in der Membran. Dieses Thema wird von Randall et al in "The Thermomechanical Stability of Ion Beam Masking", Journal of Vacuum Science & Technology, 85(1), Jan./Feb. 1987, S. 223-227, genau beschrieben. Die allgemeine Schlußfolgerung dieser Arbeit besagt, daß zur Erreichung akzeptabler Verzerrungswerte die Zugbeanspruchung der Siliziummembran unter 3 × 10⁷ N/m² (3 × 10⁸ Dyn/cm²) gehalten werden muß. Dieselbe Überlegung betrifft auch jede zusätzliche Schicht, die auf die Siliziummembran aufgebracht wird.

Ebenso ist es von Bedeutung, daß die Membran unter ausreichender Zugspannung stehen muß, um plan zu bleiben. Sie muß plan sein, um Bilder hoher Auflösung auf einem Schaltungschip, unter Verwendung einer Membran als Maske, erzeugen zu können. Der oben erwähnte Stand der Technik zur Herstellung großflächiger Silizium-Schattenmasken behandelte das vorstehende Problem nicht entsprechend. Wenn nicht zusätzlich Maßnahmen zur Kompensation der Spannungen angewendet werden, weisen Membranen aus p+ Material auf leicht dotierten Substraten Spannungswerte auf, die um einiges höher sind als jener Bereich, der von Randall als erforderlich beschrieben wird. Die Spannungen der verschiedenen verwendeten Maskierungsschichten werden in diesen Verfahren auch nicht kontrolliert. Eine Zielsetzung der vorliegenden Erfindung ist es daher, ein Verfahren zur Herstellung von Silizium-Schattenmasken zu schaffen, das Spannungswerte innerhalb des verhältnismäßig begrenzten, erforderlichen Bereiches aufrecht halten kann, wodurch Masken mit geringer Verzerrung hergestellt werden können.

### ZUSAMMENFASSUNG DER ERFINDUNG

Ausgehend von einem Verfahren gemäß dem Oberbegriff des Anspruchs 1 wird die oben erwähnte Zielsetzung durch die Merkmale des kennzeichnenden Teils dieses Anspruchs 1 erreicht.

Die vorliegende Erfindung schafft ein Verfahren zur Herstellung von hochauflösenden Schattenmasken mit geringer Strukturverzerrung. Die Maske besteht aus einer Siliziummembran, mit einer Struktur von Öffnungen, die durch die Membran durch reaktives Ionenstrahlätzen unter Verwendung von Siliziumdioxid-Maskierungsschichten hindurchgeätzt werden. Damit eine geringe Verzerrung über großflächigen Membranen erzielt werden kann, wird die Spannung der Membran und der Maskierungsschicht kontrolliert, um innerhalb eines optimalen Bereichs zu bleiben, sodaß ein Absinken der Spannung, das beim Ausformen der Öffnungen auftritt, vernachlässigbar gering gehalten wird.

Das Maskenherstellungsverfahren wird unter Verwendung einer Membran mit einem kontrollierten Spannungswert durchgeführt. Siliziummembranen mit kontrollierter Spannung werden in einem elektrochemischen Ätz-Stopp-Verfahren des p/n-überganges hergestellt. Letzteres Verfahren ist Gegenstand der EP-A-367 750, die unter Artikel 54(3) EPÜ fällt. Nach der Herstellung der Membran wird diese mit einer Siliziumdioxidschicht überzogen. Das Siliziumdioxid dient als Moskierungsschicht für das Ätzen der öffnungen durch die Siliziummembran hindurch. Die Oxidschicht sollte auf die Membran eher aufgetragen als durch thermisches Wachsen erzeugt werden. Zu den Verfahren für das Auftragen von Oxidschichten zählen die chemische Abscheidung aus der Gasphase bei der Zersetzung von Silan, thermisches Aufdampfen und Sputtern (Kathodenzerstäubung). Die Spannung der Oxidschicht wird nach dem Auftragen durch Ausheilen auf einen optimalen Wert eingestellt.

Die Membran mit der Oxidmaskierungsschicht wird danach mit einer Photoresistschicht überzogen, die dann mit der gewünschten Schattenmaskenstruktur strukturiert wird. Sobald der Photoresist strukturiert ist, wird die Struktur in die Oxidschicht durch reaktives Ionenstrahlätzen übertragen. Das strukturierte Oxid dient dann als Maske beim Ätzen der Öffnungen in das Silizium, was wiederum durch reaktives Ionenstrahlätzen geschieht. Während dieser beiden Strukturierungsschritte tritt ein Absinken der Spannung auf, das auf das Entfernen des Materials in jenen Bereichen, die mit öffnungen versehen werden, zurückzuführen ist.

Nachdem das Silizium geätzt wurde, wird jede verbliebene Oxid entfernt. Hiebei kommt es erneut zu einem Absinken der Spannung. Die Größe der Spannungsverminderung hängt von der Größe der Membran, den besonderen Einzelheiten der Struktur und dem Spannungsniveau in der Silizium- und Siliziumdioxidschicht ab. Das Spannungsniveau ist jedoch kontrolliert, damit Strukturen hoher Auflösung über Flächen erfolgreich hergestellt werden können, die so groß sind, daß sie für die Herstellung von höchstintegrierten Halbleiterelementen brauchbar sind.

### KURZE BESCHREIBUNG DER ZEICHNUNGEN

Figur 1 veranschaulicht einen schematischen Querschnitt durch eine Siliziummembran, die zur Herstellung einer erfindungsgemäßen Schattenmaske verwendet wird. Die

Figuren 2 bis 7 veranschaulichen die Verfahrensschritte der vorliegenden Erfindung.

Figur 8 ist ein schematischer Querschnitt der fertigen Schattenmaske.

Figur 9 veranschaulicht einen weiteren Verfahrensschritt zur Metallisierung der Schattenmaske aus Figur 8.

### AUSFÜHRLICHE BESCHREIBUNG DER ERFINDUNG

In der folgenden Beschreibung, die der nichteinschränkenden Erläuterung dient, sind genaue Zahlen, Abmessungen, Materialien usw. dargelegt, um ein umfassendes Verständnis der vorliegenden Erfindung zu ermöglichen. Der Fachmann erkennt jedoch, daß die vorliegende Erfindung auch in anderen Ausführungsformen, die von diesen genauen Einzelheiten abweichen, verwirklicht werden kann. Anderseits wird auf allgemein bekannte Verfahren zur Bearbeitung von Halbleitermaterialien verwiesen, ohne näher darauf einzugehen, um die Beschreibung der vorliegenden Erfindung nicht mit unnötigen Einzelheiten undeutlich zu machen.

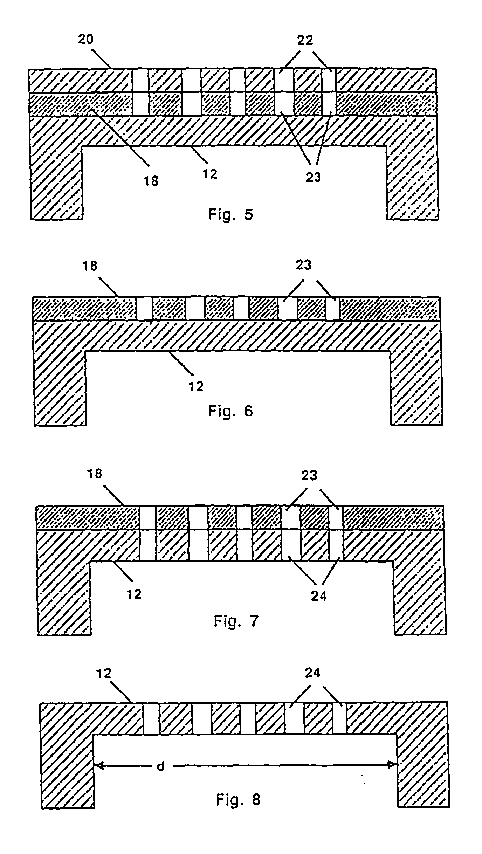

Mit kurzer Bezugnahme auf Figur 8 wird ein schematischer Querschnitt einer fertigen Silizium-Schattenmaske, die nach dem erfindungsgemäßen Verfahren hergestellt wurde, dargestellt. Es sollte beachtet werden, daß Figur 8, wie auch die anderen Figuren, rein schematischer Art sind, und die Abmessungen der Maske somit nicht maßstabgetreu sind. Insbesondere sind die Abmessungsrelationen in vielen Beispielen wegen der allgemein deutlicheren Darstellung stark verzerrt. Die Maske, die in Figur 8 dargestellt ist, besteht aus einem Siliziumwafer 10, der vom Boden aus geätzt wurde, um eine Membran 12 mit einem Durchmesser d zu bilden. Die öffnungen 24 in der Membran 12 lassen Elektronen oder Ionen durch die Maske hindurch und bestimmen die Struktur, die herzustellen ist.

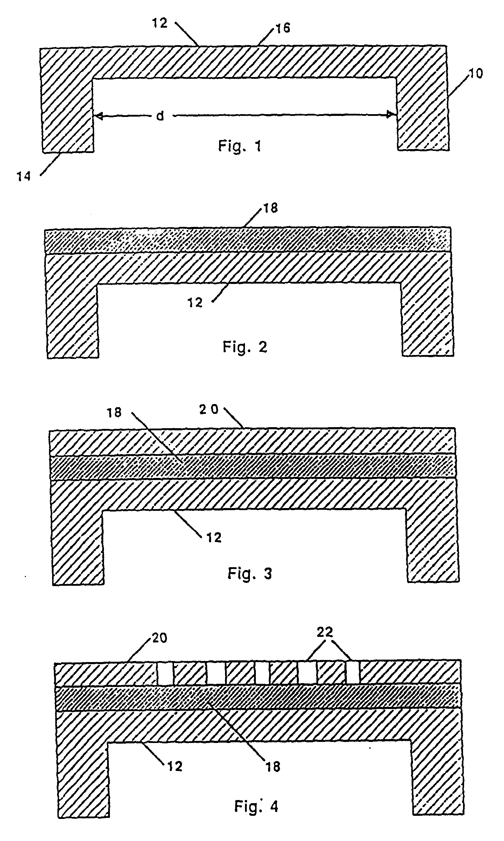

Das Verfahren zur Herstellung der Schattenmaske aus Figur 8 beginnt mit der Bildung einer Siliziummembran. Ein Querschnitt einer "rohen" Membran ist in Figur 1 dargestellt. Die Stärke eines Siliziumwafers 10 wurde vermindert, um eine Membran 12 mit einem Durchmesser d zu erhalten. Wie oben erwähnt, muß der Durchmesser d der Membran 12 zumindest 2 cm oder mehr betragen, um für höchstintegrierte (VLSI) lithographische Anwendungen brauchbar zu sein. Wie ebenso oben erwähnt, muß die Spannung der Membran derart kontrolliert sein, daß sie im Bereich von etwa 0,5 bis 3,0 × 10⁷ N/m² (10⁸ Dyn/cm²) Zugspannung liegt, um die Strukturverzerrung auf ein Minimum zu reduzieren. Ein Verfahren zur Herstellung von Membranen mit diesen Eigenschaften ist Gegenstand der gleichzeitig anhängigen Patentanmeldung mit der Nr. 89 890 238.2-2203 (EP-A- 367 750), auf deren Beschreibung hier Bezug genommen wird. Unter Anwendung eines derartigen Verfahrens werden großflächige Siliziummembranen mit kontrollierter Spannung unter Anwendung eines elektrochemischen Ätz-Stopp-Verfahrens des p/n-überganges hergestellt.

Die Membranen werden unter Verwendung von herkömmlichen, im Handel erhältlichen Siliziumwafern als Ausgangsmaterial hergestellt. Derartige Wafer sind üblicherweise mit Durchmessern von etwa 3, 4, 5 und 6 Zoll erhältlich. Die Größe des Wafers wird so gewählt, daß sie der Membranstruktur entspricht, die für eine bestimmte Anwendung wünschenswert ist. Die maximale Membrangröße, die auf einem gegebenen Wafer erzielt werden kann, ist etwa um 1 Zoll geringer als der Waferdurchmesser, um einen Rand 14 von nicht geätztem Material, wie in Figur 1 dargestellt, zu erhalten. Dieser Rand dient dazu, der Struktur mechanische Steifheit zu verleihen und die Handhabung zu ermöglichen. Anstelle der einen großen Membran, die in Figur 1 dargestellt ist, können mehrere kleinere Membranen erzeugt werden. Die Stärke der Membranen, die unter Anwendung des oben erwähnten Verfahrens hergestellt werden, kann von weniger als einem Mikron bis zu 25 µm schwanken, abhängig von der Größe der Membran. Membranen mit einem Durchmesser von zwei Zoll wurden mit einer Stärke von nur 0,75 µm hergestellt. Bei großflächigeren Membranen ist die geringste Stärke größer. Für eine Membran mit einem Durchmesser von 4 Zoll ist eine Stärke von etwa 2 µm erforderlich.

Nach der Herstellung der Membran 12 wird die obere Fläche 16 mit einer Siliziumdioxidschicht 18 bedeckt, wie in Figur 2 dargestellt ist. Es ist wichtig, daß die Oxidschicht 18 auf die Membranoberfläche aufgetragen und nicht thermisch aufgebaut wird. Thermische Oxide werden üblicherweise auf einen Siliziumwafer aufgebaut, indem der Wafer einer Sauerstoff- oder Dampfatmosphäre bei 900° bis 1.100° C ausgesetzt wird. Oxidschichten, die durch dieses Verfahren gebildet werden, haben innere Druckspannungswerte von mehr als 1 × 10⁸N/m² (1 × 10⁹ Dyn/cm²), wenn sie auf Raumtemperatur abgekühlt werden, aufgrund der unterschiedlichen Wärmeausdehnung von Oxid und Silizium. Derart hohe Drucksapnnungswerte in der Oxidschicht verursachen Falten oder Verzerrungen in der Membran, selbst bei sehr dünnen Oxidschichten.

Anstelle der thermisch gewachsenen Oxidschichten kann eine aufgetragene Schicht aus Siliziumdioxid verwendet werden. Allgemein bekannte Verfahren für das Auftragen von Oxidschichten sind Abscheiden aus der Gasphase, Aufdampfen und Sputtern (Kathodenzerstäubung). Mit diesen Verfahren können Oxidschichten mit einer Stärke bis etwa 1,5 Mikron abgelagert werden. Die erforderliche Stärke der Oxidschicht hängt von der Stärke der darunterliegenden Siliziummembran ab, die durch reaktives Ionenstrahlätzen durchgeätzt wird, und von dem Erosionsmaß der Oxidmaske in diesem Verfahren. Wie in der Folge beschrieben wird, werden unter allgemeinen Verfahrensbedingungen für das reaktive Ionenstrahlätzen bei Silizium Oxidstärken von 0,25 bis 0,75 µm üblicherweise für Membranstärken von 2 bis 5 µm verwendet.

Der prinzipielle Vorteil bei der Verwendung von abgelagerten Oxidschichten gegenüber thermisch gewachsenen Oxidschichten besteht darin, daß die Spannungswerte der abgelagerten Schichten durch thermisches Ausheilen eingestellt werden können, so daß sie im erforderlichen Bereich für die Herstellung einer Maske mit geringer Verzerrung liegen. Das thermische Ausheilen von aufgetragenen Filmen wird von Y. Shioya et al in "Comparison of Phosphosilicate Glass Films Deposited by Three Different Chemical Vapor Deposition Methods", Journal of the Electrochemical Society, 133 (9), Sept. 1986, S. 1943-1950, beschrieben. Nach dem Ablagdern ist die Filmspannung eine Druckspannung. Nach dem Ausheilen in einer Stickstoffatmosphäre verändert sich die Spannung im Film von dem anfänglichen Druckwert auf einen maximalen Zugspannungswert bei Ausheiltemperaturen im Bereich von 500° - 600° C. Das Ausheilen bei höheren Temperaturen läßt die Spannung wieder zur Druckspannung werden. Durch die richtige Wahl der Ausheiltemperatur kann die Spannung der Oxidschicht so gewählt werden, daß die Strukturverzerrung minimal ist. Ein geringer Zugspannungswert von weniger als 1 × 10⁷ N/m² (1 × 10⁸ Dyn/cm²) wird für die meisten Anwendungsformen als optimal betrachtet.

Nach dem Ablagern und Ausheilen der Oxidschicht wird eine Schicht aus Photoresist 20, wie in Figur 3 dargestellt, aufgetragen. Der Photoresist wird dann unter Anwendung herkömmlicher Verfahren belichtet und entwickelt, um die Strukturöffnungen 22, die in Figur 4 dargestellt sind, auszubilden. Die Resiststruktur wird als Maske für das reaktive Ionenstrahlätzen der Oxidschicht 18 verwendet, um Öffnungen 23 zu ätzen, die in Figur 5 dargestellt sind. übliche Verfahren für das Oxidätzen werden von G.Z. Yin et al in "Etch Silicon Dioxide with High Selectivity and Low Polymer Formation", Semiconductor International, Sept. 1988, S. 110-114, beschrieben. Das Erosionsmaß der Resistschicht während dieses Verfahrens liegt unter 10 % der Ätzrate der Oxidschicht für dieses Verfahren. Daher gehen bei Oxidschichten von weniger als 1 µm Stärke weniger als 0,1 µm Resist verloren. Ausgangsresiststärken im Bereich von 0,3 bis 0,5 µm sind angemessen, um eine Maskierung für das Oxidätzen ohne Verlust der Strukturdefinition zu schaffen. Nach Vollendung des Oxidätzens wird der verbleibende Resist auf der Maske durch Ablösen in einem Sauerstoffplasma entfernt, wie es im allgemeinen bei Siliziumwafern geschieht, um somit die Struktur, die in Figur 6 dargestellt ist, zu erhalten.

Die strukturierte Oxidschicht dient nun als Maske für das reaktive Ionenstrahlätzen der Siliziummembran, wie in Figur 7 dargestellt ist. Für diesen Schritt gibt es zwei alternative Verfahren. In einem Fall wird das Ätzen des Siliziums durch die Verwendung von reaktiven Gasplasmen auf Brombasis erzielt, wobei alternativ auch Plasmen auf Chlorbasis verwendet werden können. Im Fall von Brom kann das Plasma entweder aus Dampf von flüssigen Bromlösungen oder aus einer Wasserstoff-Bromidgasquelle erhalten werden. Beschreibungen des Siliziumätzens unter Verwendung von Brom findet man bei F.O. Fong et al, "High-Resolution Fabrication Process for Silicon Ion Masks", Journal of Vacuum Science Technology, 86(6), Nov./Dez. 1988, S. 2112-2114. Im Fall von Chlorätzen werden Gasquellen wie CCl₄ oder Cl₂ verwendet, wie es von M. Ameer et al in "Silicon Trench Etching Made Easy", Semiconductor International, Sept. 1988, S. 122-128, beschrieben wird.

Das Silizium der Membran 12 wird unter Verwendung der strukturierten Oxidschicht 18 als Maske vollständig durchgeätzt, um öffnungen 24 in der Membran 12 auszubilden, durch die ein Strahl geladener Teilchen hindurchgehen kann. Die verbliebene Oxidschicht 18 kann danach entweder durch weiteres reaktives Ionenstrahlätzen oder durch chemisches Wegätzen in einer Lösung von Fluorwasserstoffsäure entfernt werden. Das Endergebnis ist eine fertige Silizium-Schattenmaske, die in Figur 8 dargestellt ist.

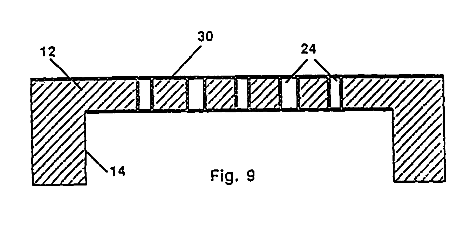

Eine andere Ausführungsform einer fertigen Schattenmaske ist in Figur 9 dargestellt. In diesem Fall wird ein zusätzlicher Verfahrensschritt durchgeführt, um die Siliziummaske mit einer dünnen Metallschicht 30 zu überziehen, um einen Ladungsausgleich zu schaffen. Während der Belichtung mit einem Strahl geladener Teilchen neutralisiert die Metallschicht 30 die elektrische Ladung der Teilchen, die auf die Masken oberfläche auftreffen, die die öffnungen 24 umgibt.

## Patentansprüche

1. Verfahren zur Herstellung einer hochauflösenden Silizium-Schattenmaske mit einer Struktur von durchgeätzten Öffnungen, zur Verwendung für Elektronen-, Ionenstrahl- oder Röntgenlithographie, Ionenimplantation und Ionenstrahlätzung, wobei das Verfahren die folgenden Schritte aufweist:
a) Herstellen einer Siliziummembran (12) mit einer Stärke von weniger als 25 µm,
b) nichtthermisches Ablagern einer Siliziumdioxidschicht (18) an einer Oberfläche (16) der Siliziummembran (12),
c) Strukturieren der Siliziumdioxidschicht mit einer Struktur (22), die der Struktur der durch zu ätzenden Öffnungen entspricht,
d) reaktives Ionenstrahlätzen der Siliziumdioxidschicht in Bereichen, die der Struktur der durch zu ätzenden Öffnungen entsprechen,
e) reaktives Ionenstrahlätzen der Siliziummembran in Bereichen, die der Struktur der durch zu ätzenden Öffnungen entsprechen, wodurch die durchgeätzten Öffnungen (24) geschaffen werden, und
f) Entfernen der verbliebenen Teile der Siliziumdioxidschicht (18),
**dadurch gekennzeichnet, daß**
bei dem Schritt a) der Herstellung der Siliziummembran (12) mit Hilfe eines elektrochemischen Ätzstopverfahrens eines p/n-Überganges eine selektiv kontrollierte, vorherbestimmte Spannungscharakteristik dieser Siliziummembran erzeugt wird,
**und daß**
nach dem Schritt b) des nichtthermischen Ablagerns der Siliziumdioxidschicht (18) durch thermisches Nachbehandeln ein vorbestimmter Spannungszustand dieser Siliziumdioxidschicht erzeugt wird.

2. Verfahren nach Anspruch 1, **dadurch gekennzeichnet, daß** die Siliziumdioxidschicht (18) durch chemische Abscheidung aus der Gasphase, durch Aufdampfen oder durch Aufsputtern hergestellt wird.

3. Verfahren nach Anspruch 1, **dadurch gekennzeichnet, daß** die SiO₂-Schicht (18) in einer Stickstoffatmosphäre thermisch nachbehandelt wird, bis ein innerer Zugspannungswert von 1 × 10⁷ N/m² (=1×10⁸ Dyn/cm²) erreicht wird.

4. Verfahren nach Anspruch 1, **dadurch gekennzeichnet, daß** die selektiv kontrollierte, vorbestimmte Spannungseigenschaft der Siliziummembran (12) ein innerer Zugspannungswert im Bereich von 0,5 bis 3,0×10⁷ N/m² (=0,5 bis 3,0×10⁸ Dyn/cm²) ist.

5. Verfahren nach Anspruch 1, **dadurch gekennzeichnet, daß** die Siliziumdioxidschicht (18) mittels einer Photoresistschicht (20) strukturiert wird, wobei nach dem Schritt des reaktiven Ionenstrahlätzens der Siliziumdioxidschicht (18) das Entfernen der Photoresistschicht (20) in einem Sauerstoffplasma vorgesehen ist.

6. Verfahren nach Anspruch 1, **dadurch gekennzeichnet, daß** zum reaktiven Ionenstrahlätzen ein Bromplasma verwendet wird, welches aus einer flüssigen Bromlösung oder aus Wasserstoffbromidgas gewonnen wird.

7. Verfahren nach Anspruch 1, **dadurch gekennzeichnet, daß** zum reaktiven Ionenstrahlätzen ein Chlorplasma verwendet wird, welches aus einem Chlorgas gewonnen wird.

8. Verfahren nach Anspruch 1, **dadurch gekennzeichnet, daß** die Siliziummembran (12) in Bereichen, welche die durchgeätzten Öffnungen (24) umgeben, metallisiert wird.

## Claims

1. Process for the manufacture of a high-resolution silicon shadow mask having a structure of etched-through openings, for use for electron-beam, ion-beam or X-ray lithography, ion implantation and ion-beam etching, the process exhibiting the following steps:
a) manufacture of a silicon membrane (12) of less than 25 µm thickness,
b) non-thermal deposition of a silicon dioxide layer (18) on a surface (16) of the silicon membrane (12),
c) structuring of the silicon dioxide layer with a structure (22) matching the structure of the openings to be etched through,
d) reactive ion-beam etching of the silicon dioxide layer in regions matching the structure of the openings to be etched through,
e) reactive ion-beam etching of the silicon membrane in regions matching the structure of the openings to be etched through, whereby the etched-through openings (24) are created, and
f) removal of the remaining parts of the silicon dioxide layer (18),
**characterised in that**
in step a) involving the manufacture of the silicon membrane (12) by means of an electrochemical p-n junction, a selectively controlled, predetermined tension characteristic of this silicon membrane is produced,
**and in that**
following step b) involving the non-thermal deposition of the silicon dioxide layer (18) through thermal after-treatment, a predetermined state of tension of this silicon dioxide layer is produced.

2. Process according to Claim 1, **characterised in that** the silicon dioxide layer (18) is made by chemical separation from the gas phase, by evaporation coating or by sputtering-on.

3. Process according to Claim 1, **characterised in that** the SiO₂-layer (18) is thermally after-treated in an atmosphere of nitrogen until an inner tensile stress value of 1 x 10⁷ N/m² (= 1 x 10⁸ Dyn/cm²) is reached.

4. Process according to Claim 1, **characterised in that** the selectively controlled, predetermined tension characteristic of the silicon membrane (12) is an inner tensile stress value within the range 0.5 to 3.0 x 10⁷ N/m² (= 0.5 to 3.0 x 10⁸ Dyn/cm²).

5. Process according to Claim 1, **characterised in that** the silicon dioxide layer (18) is structured by means of a photoresist layer (20), wherein it is envisaged that the step comprising the reactive ion-beam etching of the silicon dioxide layer (18) is to be followed by the removal of the photoresist layer (20) in an oxygen plasma.

6. Process according to Claim 1, **characterised in that** for the reactive ion-beam etching a bromine plasma is used, which is extracted from a liquid bromine solution or from hydrogen bromide gas.

7. Process according to Claim 1, **characterised in that** for the reactive ion-beam etching a chlorine plasma is used, which is extracted from a chlorine gas.

8. Process according to Claim 1, **characterised in that** the silicon membrane (12) is metallised in regions surrounding the etched-through openings (24).

## Revendications

1. Procédé de fabrication d'un masque d'ombre en silicium à haute résolution avec une structure d'ouvertures réalisées par attaque chimique, destiné à être utilisé pour une lithographie par électrons, par faisceau d'ions ou par rayons X, une implantation d'ions et une attaque chimique par faisceau d'ions, ledit procédé comprenant les étapes suivantes :
a) fabrication d'une membrane de silicium (12) ayant une épaisseur inférieure à 25 µm,
b) dépôt non thermique d'une couche de dioxyde de silicium (18) sur une surface (16) de la membrane de silicium (12),
c) structuration de la couche de dioxyde de silicium avec une structure (22) qui correspond à la structure des ouvertures à réaliser par attaque chimique,
d) attaque réactive de la couche de dioxyde de silicium au moyen d'un faisceau d'ions dans des zones qui correspondent à la structure des ouvertures à réaliser par attaque chimique,
e) attaque réactive de la membrane de silicium au moyen d'un faisceau d'ions dans des zones qui correspondent à la structure des ouvertures à réaliser par attaque chimique, grâce à quoi les ouvertures (24) réalisées par attaque chimique sont créées, et
f) élimination des parties restantes de la couche de dioxyde de silicium (18),
caractérisé en ce que, dans l'étape a) de fabrication de la membrane de silicium (12) à l'aide d'un procédé électrochimique de stoppage d'attaque chimique d'une jonction p/n, une caractéristique de tension prédéterminée, contrôlée sélectivement, de cette membrane de silicium est produite, et en ce que, après l'étape b) de dépôt non thermique de la couche de dioxyde de silicium (18), un état de tension prédéterminé de cette couche de dioxyde de silicium est produit au moyen d'un post-traitement thermique.

2. Procédé selon la revendication 1, caractérisé en ce qu'on fabrique la couche de dioxyde de silicium (18) par dépôt chimique en phase gazeuse, par métallisation sous vide ou par pulvérisation.

3. Procédé selon la revendication 1, caractérisé en ce qu'on soumet la couche de SiO₂ (18) à un post-traitement thermique dans une atmosphère d'azote jusqu'à l'obtention d'une valeur de contrainte de traction de 1 x 10⁷ N/m² (= 1 x 10⁸ dyn/cm²) .

4. Procédé selon la revendication 1, caractérisé en ce que la propriété de tension prédéterminée, contrôlée sélectivement, de la membrane de silicium (12) est une valeur de contrainte de traction interne comprise entre 0,5 et 3,0 x 10⁷ N/m² (= 0,5 à 3,0 x 10⁸ dyn/cm²).

5. Procédé selon la revendication 1, caractérisé en ce que la couche de dioxyde de silicium (18) est structurée au moyen d'une couche de photorésist (20), et après l'étape d'attaque chimique réactive de la couche de dioxyde de silicium (18) au moyen d'un faisceau d'ions, il est prévu l'élimination de la couche de photorésist (20) dans un plasma d'oxygène.

6. Procédé selon la revendication 1, caractérisé en ce qu'on utilise, pour l'attaque réactive au moyen d'un faisceau d'ions, un plasma de brome qu'on obtient à partir d'une solution liquide de brome ou de gaz bromure d'hydrogène.

7. Procédé selon la revendication 1, caractérisé en ce qu'on utilise, pour l'attaque réactive au moyen d'un faisceau d'ions, un plasma de chlore qu'on obtient à partir de gaz chlore.

8. Procédé selon la revendication 1, caractérisé en ce qu'on métallise la membrane de silicium (12) dans les zones qui sont entourées par les ouvertures (24) réalisées par attaque chimique.
